# EUROPÄISCHE PATENTSCHRIFT

(11) **EP 3 742 514 B1**
(45) Veröffentlichungstag und Bekanntmachung des Hinweises auf die Patenterteilung: **20.03.2024**
(21) Anmeldenummer: 19175460.5
(22) Anmeldetag: 20.05.2019
(51) Int. Cl.: H01M 50/119, H01M 50/124, H01M 50/56

(54) **VERFAHREN ZUR HERSTELLUNG EINER BATTERIE UND GEMÄSS DEM VERFAHREN HERGESTELLTE BATTERIE**
METHOD FOR PRODUCING A BATTERY AND BATTERY PRODUCED ACCORDING TO THE METHOD
PROCÉDÉ DE FABRICATION D'UNE BATTERIE ET BATTERIE FABRIQUÉE SELON LEDIT PROCÉDÉ

(43) Veröffentlichungstag der Anmeldung: 25.11.2020
(73) Patentinhaber: VARTA Microbattery GmbH, 73479 Ellwangen Jagst (DE)
(72) Erfinder: Kilibarda, Goran, 73525 Schwäbisch Gmünd (DE); Kreidler, Bernd, 73479 Ellwangen (DE); Rieger, Joachim, 73433 Aalen (DE)
(74) Vertreter: Ostertag & Partner Patentanwälte mbB

(56) Entgegenhaltungen:
- EP-A2- 1 505 668
- JP-A- 2002 216 772

## Beschreibung

Die nachfolgend beschriebene Erfindung betrifft ein Verfahren dient zur Herstellung einer Batterie und eine gemäß dem Verfahren herstellbare Batterie.

Knopfzellen weisen meist ein zylindrisches Gehäuse auf, dessen Höhe gleich seinem Durchmesser oder kleiner als dieser ist. In dem Gehäuse können sehr unterschiedliche elektrochemische Systeme enthalten sein. Sehr verbreitet sind Zellen auf Basis von Zink/Luft, Zink/MnO₂ und Nickel/Zink. Auch sekundäre (wiederaufladbare) Systeme sind sehr verbreitet. Beispiele hierfür sind Nickel/Metallhydrid-, Nickel/Cadmium- und Lithium-Ionen-Systeme.

Das Gehäuse von Knopfzellen besteht klassisch in aller Regel aus zwei festen, metallischen Gehäuseteilen, zwischen denen eine elektrisch isolierende Dichtung angeordnet ist. Eines der Gehäuseteile steht in elektrischer Verbindung mit der positiven Elektrode und ist entsprechend positiv gepolt. Das andere steht in elektrischer Verbindung mit der negativen Elektrode und ist entsprechend negativ gepolt. Die Dichtung soll einen elektrischen Kontakt zwischen den entgegengesetzt gepolten Gehäuseteilen unterbinden. Darüber hinaus soll sie einem Entweichen und auch einem Eindringen von Flüssigkeit oder Feuchtigkeit aus dem oder in das Gehäuse entgegenwirken. Gewöhnlich sind die Gehäuseteile aus mit Nickel plattiertem Stahl oder aus Edelstahl gefertigt.

Im Fall einer Knopfzelle auf Lithium-Ionen-Basis enthält das Gehäuse in vielen Fällen einen Verbundkörper in Form eines Zellenstapels (stack), der aus mehreren Einzelzellen besteht. Oft enthalten die Zellen auch einen gewickelten Verbundkörper (kurz: Wickelverbundkörper), bei dem es sich in der Regel um eine Einzelzelle in gewickelter Form handelt. Knopfzellen mit Wickelverbundkörpern auf Lithium-Ionen-Basis sind beispielsweise in der WO 2010/146154 A2 und in der WO 2010/089152 A1 beschrieben.

In den Verbundkörpern liegen in der Regel positive und negative Elektroden sowie Separatoren flach aufeinander. Meist sind die Elektroden und Separatoren beispielsweise durch Lamination oder durch Verklebung miteinander verbunden. In der Regel umfassen Verbundkörper, unabhängig davon ob gewickelt oder nicht, die Sequenz positive Elektrode / Separator / negative Elektrode. Häufig werden Verbundkörper als sogenannte Bizellen mit den möglichen Sequenzen negative Elektrode / Separator / positive Elektrode / Separator / negative Elektrode oder positive Elektrode / Separator / negative Elektrode / Separator / positive Elektrode hergestellt.

Die Elektroden in den Verbundkörpern umfassen üblicherweise jeweils einen metallischen Stromkollektor sowie elektrochemisch aktive Komponenten (oft auch als Aktivmaterialien bezeichnet) und elektrochemisch inaktive Komponenten.

Die Stromkollektoren dienen dazu, die elektrochemisch aktiven Komponenten möglichst großflächig elektrisch zu kontaktieren. Sie bestehen üblicherweise aus bandförmigen, flächigen Metallsubstraten, beispielsweise aus Metallfolien oder aus einem Metallschaum oder aus einem metallisierten Vlies. Im Fall von Zellen auf Lithium-Ionen-Basis weisen die negativen Elektroden meist einen Stromkollektor aus Kupfer oder aus einer Kupferlegierung auf. Die positiven Elektroden von Zellen auf Lithium-Ionen-Basis weisen meist einen Stromkollektor aus Aluminium oder aus einer Aluminiumlegierung auf.

Als Aktivmaterialien kommen für sekundäre Lithium-Ionen-Systeme sämtliche Materialien in Frage, die Lithium-Ionen aufnehmen und wieder abgeben können. Stand der Technik sind diesbezüglich für die negative Elektrode sekundärer Lithium-Ionen-Systeme insbesondere Materialien auf Kohlenstoffbasis wie graphitischer Kohlenstoff oder zur Interkalation von Lithium befähigte nichtgraphitische Kohlenstoffmaterialien. Für die positive Elektrode sekundärer Lithium-Ionen-Systeme kommen beispielsweise Lithium-Metalloxid-Verbindungen und Lithium-Metallphosphat-Verbindungen wie LiCoO₂ und LiFePO4in Frage.

Als elektrochemisch inaktive Komponenten sind an erster Stelle Elektrodenbinder und Leitmittel zu nennen. Die Elektrodenbinder gewährleisten die mechanische Stabilität der Elektroden und sorgen für die Kontaktierung der Partikel aus elektrochemisch aktivem Material untereinander sowie zum Stromkollektor. Leitmittel wie Ruß dienen dazu, die elektrische Leitfähigkeit der Elektroden zu erhöhen.

Als Separatoren kommen für die genannten Verbundkörper insbesondere Bänder aus porösen Kunststofffolien in Frage, beispielsweise aus einem Polyolefin oder aus einem Polyetherketon. Auch Vliese und Gewebe, insbesondere aus diesen Materialien, können zum Einsatz kommen

Endständige Abschnitte der Stromkollektoren oder an die Stromkollektoren angeschweißte Stromleiter können dazu dienen, einen elektrischen Kontakt zwischen den Elektroden und den Gehäuseteilen eines Knopfzellengehäuses herzustellen. Im Fall von Knopfzellen sind die positiven Elektroden der Verbundkörper mit einem der zwei erwähnten Gehäuseteile eines Knopfzellengehäuses elektrisch zu verbinden, negative Elektroden mit dem anderen der Gehäuseteile.

Die Gehäuseteile einer Knopfzelle weisen in der Regel jeweils einen kreisrunden oder ovalen Boden auf. In den meisten Fällen ist es bevorzugt, die Stromkollektoren oder die daran angeschweißten Stromleiter mit diesen Böden zu verbinden, insbesondere an diese Böden anzuschweißen. Dies ist nicht immer unproblematisch. Schweißverbindungen zwischen unterschiedlichen Metallen sind manchmal schwierig zu bilden und elektrochemisch instabil. In der Folge kann es zu Prozessschwankungen und dadurch zu Ausschuss kommen.

Aus der EP 3 121 865 B1 ist es bekannt, den Boden eines Gehäuseteils mit einer dünnen Aluminiumscheibe abzudecken und den endständigen Abschnitt eines Stromkollektors aus Aluminium nicht unmittelbar am Gehäuseboden sondern an der Aluminiumscheibe anzuschweißen. Die ist insoweit nachteilhaft, als die Aluminiumscheibe das verfügbare Innenvolumen des beschriebenen Knopfzellengehäuses reduziert. Darüber hinaus erhöht sich durch das Einlegen der Aluminiumscheibe der Innenwiderstand.

Aus der EP 1505668 A2 und der JP 2002-216772 A sind Zellen mit alkalischem Elektrolyten bekannt. Zur Vermeidung einer Wasserstoffentwicklung in Folge einer Elektrolytzersetzung wird auf die Innenseite ihrer Zellgehäuse eine Schicht aus Zinn aufgesputtert.

Der vorliegenden Erfindung lag die Aufgabe zugrunde, eine verbesserte Lösung zur elektrischen Kontaktierung der Elektroden einer Batterie mit einem ihrer Gehäuseteile bereitzustellen.

Zur Lösung dieser Aufgabe schlägt die Erfindung ein Verfahren mit den in Anspruch 1 genannten Merkmalen sowie eine Batterie mit den in Anspruch 8 genannten Merkmalen vor. Weiterbildungen der Erfindung sind Gegenstand von Unteransprüchen.

Das erfindungsgemäße Verfahren dient zur Herstellung einer Lithium-Ionen-Batterie, welche die folgenden Merkmale aufweist:
a. Sie umfasst ein metallisches, einen Innenraum einschließendes Gehäuse,
b. sie umfasst einen in dem Innenraum angeordneten Verbundkörper aus mindestens einer positiven Elektrode, mindestens einer negativen Elektrode und mindestens einem Separator, wobei die Elektroden dazu ausgebildet sind, Lithium-Ionen reversibel ein- und auslagern zu können,
c. das Gehäuse umfasst ein erstes becherförmiges Gehäuseteil sowie ein zweites Gehäuseteil,
d. das becherförmige erste Gehäuseteil umfasst einen kreisförmigen oder ovalen Boden,
e. das becherförmige erste Gehäuseteil umfasst einen ringförmigen Mantel,
f. der Boden und der Mantel des ersten becherförmigen Gehäuseteils weisen jeweils eine in den Innenraum weisende Innenseite und eine in die entgegengesetzte Richtung weisende Außenseite auf, und
g. der Verbundkörper umfasst einen Stromleiter, der die mindestens eine positive oder die mindestens eine negative Elektrode elektrisch mit dem becherförmigen Gehäuseteil verbindet.

Das Verfahren umfasst in beliebiger Reihenfolge die folgenden Schritte:
h. Bildung einer elektrischen Verbindung zwischen dem Stromleiter und dem becherförmigen Gehäuseteil.
i. Zusammenfügen des ersten und des zweiten Gehäuseteils zu dem Gehäuse der Batterie unter Einschluss des Verbundkörpers in dem Innenraum.

Besonders zeichnet sich das Verfahren dadurch aus, dass vor den Schritten g. und h.
j. mindestens eine der genannten Innenseiten des becherförmigen Gehäuseteils ganz oder bereichsweise mittels Sputterdeposition mit einer Beschichtung aus Aluminium, Chrom, Zinn oder einer Legierung dieser Elemente versehen wird.

Es hat sich herausgestellt, dass durch die Beschichtung deutlich verbesserte Schweißergebnisse erzielbar sind. So lässt sich beispielsweise ein Stromleiter aus Aluminium sehr viel zuverlässiger an eine mit Aluminium beschichtete Innenseite schweißen als an eine Innenseite aus Stahl. Darüber hinaus ist die Schweißverbindung auch elektrochemisch stabiler. In der Folge erhöht sich die Prozessstabilität, die Impedanzwerte der hergestellten Batterien und auch deren Strombelastbarkeit sind besser als die von klassisch hergestellten Batterien.

Von besonderer Bedeutung ist vorliegend der Auftrag der Beschichtung mittels Sputterdeposition. Unter Sputtern versteht man die Zerstäubung einer Festkörperoberfläche (Target) durch Beschuß mit energiereichen Ionen oder Neutralteilchen. Dabei wird die kinetische Energie des Ions oder Neutralteilchens durch Stöße auf die Atome des Festkörpers verteilt. Erreicht ein Ausläufer der hierdurch erzeugten Stoßkaskade die Oberfläche und wird dabei einem Oberflächenatom genügend Energie übertragen, um die Oberflächenbindungsenergie zu überwinden, kann dieses als freies Teilchen den Festkörper verlassen. Es kommt zur Emission von einzelnen Atomen, Ionen, gegebenenfalls auch von molekularen Clustern.

Zur Sputterdeposition bringt man in die Nähe des Targets ein Substrat, so dass die herausgeschlagenen Atome, Ionen und/oder Cluster auf diesem kondensieren und eine Schicht bilden können. Dabei sollte in der Prozesskammer der Gasdruck so gering wie möglich sein (Vakuum), damit die Targetatome das Substrat erreichen, ohne mit Gasteilchen zusammenzustoßen. Idealerweise wird der Prozess im Hochvakuum durchgeführt.

Grundsätzlich wäre es möglich, zur Vermeidung der Sputterdeposition das erste Gehäuseteil bereits aus einem Stahlblech zu fertigen, das einlagig die Beschichtung aus Aluminium, Chrom, Zinn oder einer Legierung dieser Elemente aufweist. Hierbei würde das Stahlblech allerdings einem Tiefziehprozess unterzogen, bei dem die Beschichtung gegebenenfalls Mikro-Risse bekommt. Bei der erfindungsgemäß zum Einsatz kommenden, dem Tiefziehprozess nachgeschalteten Sputterdeposition werden diese Probleme umgangen. Im Gegenteil können sogar Risse, Unebenheiten und Verformungen, die bei der vorgeschalteten Herstellung des ersten Gehäuseteils entstanden sind, kaschiert werden.

Ganz allgemein lassen sich durch die Sputterdeposition Beschichtungen besonders hoher Güte fertigen.

Das Gehäuse und die Gehäuseteile der Batterie, das becherförmige erste Gehäuseteil und das zweite Gehäuseteil, können beispielsweise wie die Gehäuseteile der in Figur 1 der WO 2010/146154 A2 dargestellten Zelle ausgebildet sein. Bei der erfindungsgemäßen Batterie kann es sich also insbesondere auch um eine Knopfzelle handeln.

Zwischen den zwei metallischen Gehäuseteilen ist üblicherweise eine ringförmige Dichtung aus Kunststoff angeordnet, welche die Gehäuseteile elektrisch gegeneinander isoliert. Darüber hinaus soll die Dichtung einen flüssigkeitsdichten Verschluss des Gehäuses gewährleisten.

Die Gehäuseteile bestehen bevorzugt aus einem Stahl, insbesondere einem vernickelten Stahl. Im letzteren Fall ist insbesondere die Außenseite des ersten und gegebenenfalls auch des zweiten Gehäuseteils vernickelt. Weiterhin kommt als metallischer Werkstoff auch Trimetall in Frage, beispielsweise mit der Abfolge Nickel, Stahl (oder Edelstahl) und Kupfer.

Besonders bevorzugt ist das zweite Gehäuseteil wie das erste Gehäuseteil becherförmig ausgebildet, weist also gleichfalls einen kreisförmigen oder ovalen Boden und einen ringförmigen Mantel auf. In einer Weiterbildung ist es sowohl im Fall des ersten Gehäuseteils als auch im Fall des zweiten Gehäuseteils bevorzugt, dass der Boden und der ringförmige Mantel durch einen Übergangsbereich miteinander verbunden sind.

Die Übergangsbereiche umfassen bevorzugt die Bereiche der Gehäuseteile, die außerhalb der Ebene des jeweiligen Bodens liegen, jedoch noch nicht Teil des dazugehörigen Mantelbereichs sind. Die Übergangsbereiche können abgerundet ausgebildet sein, beispielsweise schulterförmig, oder auch die Form einer scharfen Kante haben.

Die Übergangsbereiche begrenzen die Mäntel jeweils zu den Böden hin. Zur anderen Seite hin werden die Mäntel in beiden Fällen bevorzugt durch eine umlaufende freie Kante begrenzt, die eine kreisförmige oder ovale Öffnung definiert.

Die ringförmigen Mäntel der Gehäuseteile weisen in bevorzugten Ausführungsformen eine zylindrische Geometrie auf. Besonders bevorzugt können die Mäntel mit den Böden jeweils einen Winkel von 90° einschließen.

Der in dem Innenraum angeordnete Verbundkörper muss sich in seinem Grundaufbau nicht von aus dem Stand der Technik bekannten Verbundkörpern unterscheiden. Er besteht wie die eingangs erwähnten Verbundkörper aus Elektroden und mindestens einem Separator. Im Falle eines Wickelverbundkörpers kann der Verbundkörper eine zylindrische oder hohlzylindrische Geometrie wie etwa die in den Figuren 3a und 3b der WO 2010/146154 A2 dargestellten Wickel-Verbundkörper aufweisen. Der Wickel ist dann aus bandförmigen Elektroden und mindestens einem bandförmigen Separator gefertigt.

Bevorzugt umfasst der Verbundkörper Elektroden mit den eingangs genannten Stromkollektoren. Bei diesen handelt es sich bevorzugt um eine Folie, ein Netz, ein Gitter, einen Schaum, ein Vlies oder ein sonstiges textiles Gebilde aus einem Metall oder einer Metalllegierung.

Die Stromkollektoren weisen bevorzugt mindestens einen Abschnitt auf, der nicht mit einem Aktivmaterial bedeckt ist. Dieser Abschnitt kann in bevorzugten Ausführungsformen unmittelbar als der Stromleiter dienen, der die mindestens eine positive oder die mindestens eine negative Elektrode elektrisch mit dem becherförmigen ersten Gehäuseteil verbindet. Alternativ kann der Stromleiter auch ein separater Leiter sein, der beispielsweise an den nicht mit dem Aktivmaterial bedeckten Abschnitt des Stromkollektors geschweißt ist. Im letzteren Fall handelt es sich bei dem Stromleiter bevorzugt um eine Metallfolie.

Besonders bevorzugt umfasst der Verbundkörper einen Stromleiter, der die mindestens eine positive Elektrode elektrisch mit dem becherförmigen ersten Gehäuseteil verbindet, und einen Stromleiter, der die mindestens eine negative Elektrode elektrisch mit dem zweiten Gehäuseteil verbindet.

Alternativ kann es auch bevorzugt sein, dass der Verbundkörper einen Stromleiter umfasst, der die mindestens eine negative Elektrode elektrisch mit dem becherförmigen ersten Gehäuseteil verbindet, und einen Stromleiter, der die mindestens eine positive Elektrode elektrisch mit dem zweiten Gehäuseteil verbindet.

Zur Bildung der elektrischen Verbindung zwischen dem Stromleiter und dem becherförmigen Gehäuseteil wird der Stromleiter bevorzugt an das erste Gehäuseteil geschweißt. Wenn der Stromleiter mit der mindestens einen positiven Elektrode elektrisch verbunden ist, so wird der Stromleiter, der mit der mindestens einen negativen Elektrode elektrisch verbunden ist, bevorzugt an das zweite Gehäuseteil geschweißt. Andernfalls wird der das zweite Gehäuseteil mit der mindestens einen positiven Elektrode verbunden.

Wenn beide Gehäuseteile becherförmig ausgebildet sind, erfolgt das Zusammenfügen des ersten und des zweiten Gehäuseteils bevorzugt, indem das erste Gehäuseteil mit der freien Kante seines Mantels voran in das zweite Gehäuseteil eingeschoben wird, so dass der ringförmige Mantel des ersten Gehäuseteils und der ringförmige Mantel des zweiten Gehäuseteils mindestens bereichsweise überlappen und einen umlaufenden, doppelwandigen Mantel bilden und die Böden des ersten und des zweiten Gehäuseteils parallel zueinander ausgerichtet sind. Alternativ kann auch das zweite Gehäuseteil mit der freien Kante seines Mantels voran in das erste Gehäuseteil eingeschoben werden, so dass der ringförmige Mantel des ersten Gehäuseteils und der ringförmige Mantel des zweiten Gehäuseteils mindestens bereichsweise überlappen und einen umlaufenden, doppelwandigen Mantel bilden und die Böden des ersten und des zweiten Gehäuseteils parallel zueinander ausgerichtet sind.

Die Dimensionen des ersten und des zweiten Gehäuseteils müssen entsprechend aneinander angepasst werden. Das Gehäuseteil, das in das andere eingeschoben werden soll, weist gewöhnlich einen Mantel mit einem kleineren Durchmesser als das andere Gehäuseteil auf. Auf den Mantel mit dem kleineren Durchmesser wird meist auch die erwähnte ringförmige Dichtung aus Kunststoff aufgeschoben bevor die Gehäuseteile zusammengefügt werden. Weiterhin wird der Verbundkörper meist in dem Gehäuseteil mit dem kleineren Mantel positioniert, bevor die Gehäuseteile zusammengefügt werden.

Zum Verschluss des Gehäuses kann in einigen Ausführungsformen die freie umlaufende Kante des größeren Gehäuseteils nach innen umgebogen werden (Bördelung). Grundsätzlich ist aber auch ein bördelfreier Verschluss möglich, wie das etwa in Figur 1 der WO 2010/146154 A2 dargestellt ist.

Die Bildung der elektrischen Verbindung kann grundsätzlich vor oder nach dem Zusammenfügen erfolgen. Im letzteren Fall kann beispielsweise eine Widerstands- oder Laserschweißung durch die Wand des Gehäuses hindurch erfolgen.

In einer bevorzugten Weiterbildung der Erfindung zeichnet sich das Verfahren durch mindestens einen der unmittelbar folgenden Schritte a. bis c. aus:
a. Die elektrische Verbindung zwischen dem Stromleiter und dem becherförmigen Gehäuseteil wird in einem mit der Beschichtung versehenen Bereich der mindestens einen Innenseite gebildet.
b. Die elektrische Verbindung wird mittels Verschweißung gebildet.
c. Der Stromleiter wird an die Innenseite des Bodens des becherförmigen Gehäuseteils geschweißt.

Besonders bevorzugt sind die unmittelbar vorstehenden Schritte a., b. und c. in Kombination miteinander realisiert. Es ist also besonders bevorzugt, dass die Innenseite des Bodens des becherförmigen Gehäuseteils mit der Beschichtung versehen ist und dass der Stromleiter an den beschichteten Boden geschweißt ist.

In einer weiteren bevorzugten Weiterbildung der Erfindung zeichnet sich das Verfahren durch mindestens einen der unmittelbar folgenden Schritte a. und b. aus:
a. Die Innenseite des Bodens wird vollständig mit der Beschichtung versehen.
b. Die Innenseite des Mantels wird teilweise mit der Beschichtung versehen.

Besonders bevorzugt sind die unmittelbar vorstehenden Schritte a. und b. in Kombination miteinander realisiert. Es ist also besonders bevorzugt, dass der Boden vollständig beschichtet wird und der Mantel lediglich teilweise. Bevorzugt wird zur teilweisen Beschichtung des Mantels ein ringförmiges Segment der Innenseite des Mantels beschichtet.

In einer weiteren bevorzugten Weiterbildung der Erfindung zeichnet sich das Verfahren durch mindestens einen der unmittelbar folgenden Schritte a. und b. aus:
a. Die Beschichtung wird auf die Innenseite des Bodens mit einer gleichmäßigen Schichtdicke aufgebracht.
b. Die Schichtdicke wird im Bereich von 10 nm bis 10 µm eingestellt.

Besonders bevorzugt sind die unmittelbar vorstehenden Schritte a. und b. in Kombination miteinander realisiert. Ganz besonders bevorzugt liegt die Schichtdicke zwischen 100 nm und 2 µm.

In einer weiteren bevorzugten Weiterbildung der Erfindung zeichnet sich das Verfahren durch mindestens einen der unmittelbar folgenden Schritte a. und b. aus:
a. Die Beschichtung wird auf die Innenseite des Bodens mit einer ungleichmäßigen Schichtdicke aufgebracht.
b. Die Schichtdicke wird im Bereich von 10 nm bis 10 µm eingestellt.

Besonders bevorzugt sind die unmittelbar vorstehenden Schritte a. und b. in Kombination miteinander realisiert. Ganz besonders bevorzugt liegt die Schichtdicke zwischen 10 nm und 5 µm.

Die Einstellung einer ungleichmäßigen Schichtdicke kann funktional und sicherheitstechnisch von Bedeutung sein. Funktional kann es von Vorteil sein, die Beschichtung in dem Bereich, in dem der Stromleiter angeschweißt werden soll, dicker auszubilden, oder aber gezielt eine Rauhigkeit der Beschichtung einzustellen. Sicherheitstechnisch von Relevanz können ungleichmäßige Schichtdicken insbesondere dann sein, wenn eine unerwünschte mechanische Verstärkung des Gehäuses auftreten könnte.

In einer weiteren bevorzugten Weiterbildung der Erfindung zeichnet sich das Verfahren durch mindestens einen der unmittelbar folgenden Schritte a. und b. aus:
a. Es wird ein becherförmiges Gehäuseteil verwendet, in dessen Boden eine Sollrissstelle eingebracht ist.
b. Bei der Sollrissstelle handelt es sich um ein Berstkreuz.

Besonders bevorzugt sind die unmittelbar vorstehenden Schritte a. und b. in Kombination miteinander realisiert.

Eine Sollrissstelle im Gehäuse dient dem Zweck, unzulässige Überdrücke abbauen zu können. Um dies im Rahmen der Erfindung gewährleisten zu können, zeichnet sich das Verfahren bevorzugt durch den unmittelbar folgenden Schritt a. aus:
a. Im Bereich der Sollrissstelle ist die Innenseite des Bodens frei von der Beschichtung oder die Beschichtung weist in diesem Bereich eine geringere Dicke auf als in anderen Bereichen des Bodens.

Die Lithium-Ionen-Batterie gemäß der vorliegenden Erfindung resultiert unmittelbar aus dem oben beschriebenen Verfahren. Sie zeichnet sich entsprechend stets durch die folgenden Merkmale aus:
a. Sie umfasst ein metallisches, einen Innenraum einschließendes Gehäuse,
b. sie umfasst einen in dem Innenraum angeordneten Verbundkörper aus mindestens einer positiven Elektrode, mindestens einer negativen Elektrode und mindestens einem Separator, wobei die Elektroden dazu ausgebildet sind, Lithium-Ionen reversibel ein- und auslagern zu können,
c. das Gehäuse umfasst ein erstes becherförmiges Gehäuseteil sowie ein zweites Gehäuseteil,
d. das becherförmige erste Gehäuseteil umfasst einen kreisförmigen oder ovalen Boden,
e. das becherförmige erste Gehäuseteil umfasst einen ringförmigen Mantel,
f. der Boden und der Mantel des ersten becherförmigen Gehäuseteils weisen jeweils eine in den Innenraum weisende Innenseite und eine in die entgegengesetzte Richtung weisende Außenseite auf, und
g. der Verbundkörper umfasst einen Stromleiter, der die mindestens eine positive oder die mindestens eine negative Elektrode elektrisch mit dem becherförmigen Gehäuseteil verbindet,

Besonders zeichnet sich die Batterie dadurch aus, dass
h. auf mindestens eine der Innenseiten ganz oder bereichsweise mittels Sputterdeposition eine Beschichtung aus Aluminium, Chrom, Zinn oder einer Legierung dieser Elemente aufgebracht ist.

Betreffend bevorzugte Ausgestaltungen der Komponenten der Batterie wird auf die Erläuterungen im Zusammenhang mit dem beschriebenen Verfahren verwiesen. Ungeachtet dessen werden einige besonders bevorzugte Merkmale der Batterie im Folgenden noch einmal herausgestellt:
- Die beanspruchte Batterie ist bevorzugt eine wiederaufladbare Lithium-ionen-Batterie. Sie weist dann entsprechend auch einen Elektrolyten auf, der ein Lithium-Leitsalz enthält.
- Die Elektroden umfassen bevorzugt jeweils einen Stromkollektor der teilweise mit einem Aktivmaterial bedeckt ist und/oder der Stromleiter ist bevorzugt ein nicht mit dem Aktivmaterial bedeckter Teil des Stromkollektors.
- Zumindest das becherförmige erste Gehäuseteil besteht bevorzugt aus Stahl oder Edelstahl und/oder die Außenseite des ersten becherförmigen Gehäuseteils ist mit einer Schicht aus Nickel bedeckt.
- Das zweite Gehäuseteil ist bevorzugt wie das erste Gehäuseteil becherförmig ausgebildet und/oder die Batterie ist bevorzugt eine Knopfzelle.

Früher wurden ausschließlich mehrere in Serie geschaltete elektrochemische Zellen in einem Gehäuse als Batterie bezeichnet. Heute werden jedoch häufig auch bereits einzelne elektrochemische Zellen als Batterie bezeichnet. Dies soll auch vorliegend so gehandhabt werden. Selbst eine Knopfzelle mit nur einer positiven und einer negativen Elektrode wird im Rahmen der vorliegenden Anmeldung als Batterie bezeichnet.

Sie Batterie ist bevorzugt eine wiederaufladbare Lithium-Ionen-Batterie und zeichnet sie sich bevorzugt durch mindestens eines der unmittelbar folgenden Merkmale a. bis c. aus:
a. Der Stromleiter besteht aus Aluminium oder aus einer Aluminiumlegierung.
b. Der Stromleiter besteht aus Kupfer oder aus einer Kupferlegierung.
c. Der Stromleiter basiert auf dem gleichen Metall wie die Beschichtung auf der mindestens einen Innenseite.

Besonders bevorzugt sind die unmittelbar vorstehenden Merkmale a. und c. sowie b. und c. in Kombination miteinander realisiert.

Idealerweise basiert der Stromleiter auch auf dem gleichen Metall wie der Stromkollektor, mit dem er verbunden ist. Im Falle von Lithium-Ionen-Batterien bestehen Stromkollektoren der positiven Elektrode häufig aus Aluminium oder einer Aluminiumlegierung, Stromkollektoren für die negative Elektrode hingegen bevorzugt aus Kupfer oder einer Kupferlegierung.

Weitere Merkmale, Einzelheiten und Vorzüge der Erfindung ergeben sich aus den Ansprüchen und der Zusammenfassung, deren beider Wortlaut durch Bezugnahme zum Inhalt der Beschreibung gemacht wird, der folgenden Beschreibung bevorzugter Ausführungsformen der Erfindung sowie anhand der Zeichnungen. Hierbei zeigen schematisch:
Figur 1 eine erfindungsgemäße Batterie im Querschnitt sowie die bei der Montage der Batterie verwendeten Komponenten und
Figur 2 einige Ausführungsformen eines Gehäuseteils der erfindungsgemäßen Batterie (gleichfalls Querschnittsdarstellung).

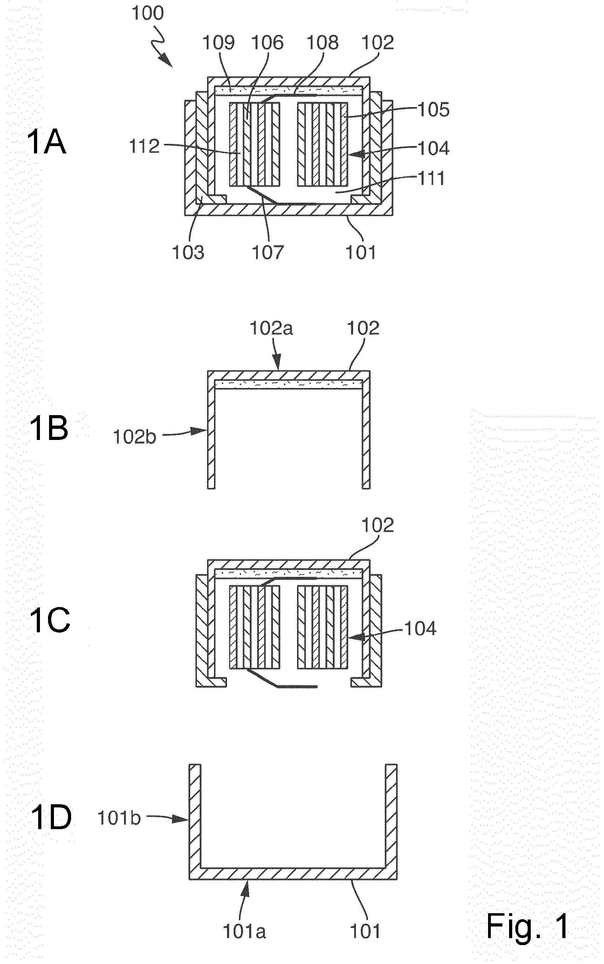

Die in Fig. 1A dargestellte Batterie 100 mit den Merkmalen weist ein Gehäuse auf, das aus dem ersten Gehäuseteil 102 und dem zweiten Gehäuseteil 101 zusammengesetzt ist. Die beiden Gehäuseteile 102 und 101 bestehen aus Stahl. Sie sind beide becherförmig. Das Gehäuseteil 102 umfasst den kreisförmigen Boden 102a und den ringförmigen Mantel 102b. Das Gehäuseteil 101 umfasst den kreisförmigen Boden 101a und den ringförmigen Mantel 101b.

Zwischen den Gehäuseteilen 102 und 101 ist die Dichtung 103 angeordnet, die das Gehäuse abdichtet. Das Gehäuse schließt einen Innenraum 111 ein, in dem der Verbundkörper 104 angeordnet ist. Dieser ist aus der positiven Elektrode 105, der negativen Elektrode 1066 und dem Separator 112 gefertigt und liegt als Wickel vor. Die Stirnseiten des Wickels weisen in Richtung der Böden 102a und 101a.

Die Elektroden 105 und 106 umfassen jeweils einen Stromkollektor, der überwiegend mit einem Aktivmaterial bedeckt und daher auch in weiten Teilen nicht sichtbar ist, abgesehen von den nicht mit Aktivmaterial bedeckten Teilbereichen 107 und 108. Diese Teilbereiche 107 und 108 fungieren vorliegend als Stromleiter. Der Stromleiter 108 verbindet die positive Elektrode 105 mit dem becherförmigen ersten Gehäuseteil 102. Über den Stromleiter 107 ist die negative Elektrode 106 mit dem zweiten Gehäuseteil 101 verbunden. Der Kollektor für die negative Elektrode 106 und damit der Stromleiter 107 ist eine Kupferfolie. Der Kollektor für die positive Elektrode 105 und damit der Stromleiter 108 ist eine Aluminiumfolie.

Der Boden 102a weist auf seiner Innenseite die Beschichtung 109 aus Aluminium auf. Diese Beschichtung wurde mittels Sputterdeposition aufgebracht. Die Beschichtung 109 weist eine gleichmäßige Schichtdicke auf, diese beträgt 10 µm. Die Innenseite des Bodens 102a ist vollständig mit der Beschichtung 109 versehen.

Der Stromleiter 108 ist mit der beschichteten Innenseite des Bodens 102a des becherförmigen Gehäuseteils 102 durch Verschweißung verbunden. Der Stromleiter 107 ist mit der Innenseite des Bodens 101a des Gehäuseteils 101 verbunden, ebenfalls durch Verschweißung.

Zur Herstellung der Batterie 100 wird diese aus dem mit der Beschichtung 109 versehenen Gehäuseteil 102 (dargestellt in Fig. 1B), dem Gehäuseteil 101 (dargestellt in Fig. 1D) und dem Verbundkörper 104 (dargestellt in Fig. 1C) zusammengefügt. Der Verbundkörper 104 wird hierzu in das Gehäuseteil 102 eingeschoben, weiterhin wird auf den Mantel 102b die Dichtung 103 aufgezogen. Das Anschwei-ßen des Stromleiters 108 erfolgt bevorzugt vor dem Schließen des Gehäuses. Beispielsweise kann hierzu eine Elektrode durch das Zentrum des Verbundkörpers 104 geführt werden und der Stromleiter 108 durch eine Widerstandsverschweißung am Boden 102a fixiert werden. Der Stromleiter 107 kann bei ausreichender Länge vor dem Schließen des Gehäuses an den Boden 101a geschweißt werden.

Ansonsten ist grundsätzlich auch ein Anschweißen nach dem Schließen des Gehäuses möglich, wie das z.B. in der WO 2010/146154 A2 beschrieben ist.

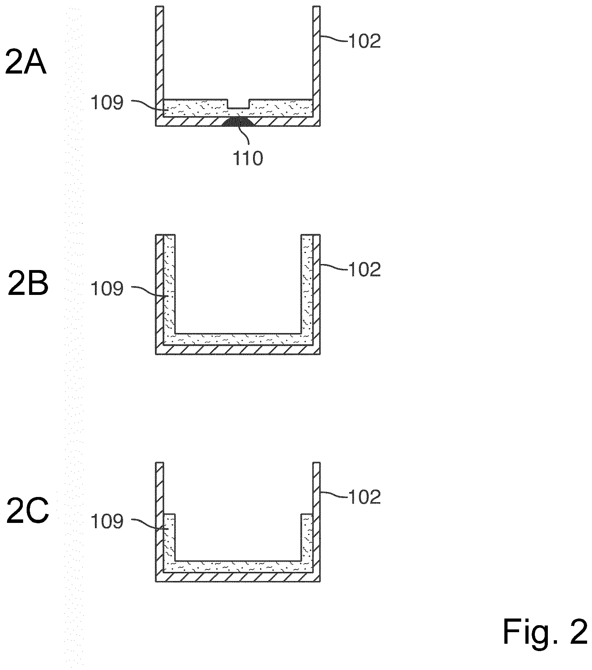

In Fig. 2 sind einige bevorzugte Ausführungsformen eines Gehäuseteils der erfindungsgemäßen Batterie dargestellt.

Während bei dem in Fig. 1 dargestellten Gehäuseteil 102 der Boden 102a in einer gleichmäßigen Dicke mit Aluminium beschichtet ist, weist die Beschichtung 109 in Fig. 2A eine ungleichmäßige Schichtdicke auf. Das hier dargestellte Gehäuseteil 102 weist eine Sollrissstelle 110 auf. Im Bereich der Sollrissstelle 110 weist die Beschichtung 109 eine geringere Dicke auf als in anderen Bereichen des Bodens 102a.

Bei dem in Fig. 2B dargestellten Gehäuseteil ist nicht nur der Boden 102a mit Aluminium beschichtet, stattdessen ist auch der Mantel 102b auf seiner Innenseite mit der Beschichtung überzogen.

Bei dem in Fig. 2C dargestellten Gehäuseteil ist der Boden 102a mit Aluminium beschichtet. Zusätzlich ist ein ringförmiger Abschnitt der Innenseite des Mantels 102b mit der Beschichtung überzogen.

## Patentansprüche

1. Verfahren zur Herstellung einer Lithium-Ionen-Batterie (100) mit den Merkmalen
a. Sie umfasst ein metallisches, einen Innenraum (111) einschließendes Gehäuse (101, 102), und
b. Sie umfasst einen in dem Innenraum (111) angeordneten Verbundkörper (104) aus mindestens einer positiven Elektrode (105), mindestens einer negativen Elektrode (106) und mindestens einem Separator (112), wobei die Elektroden dazu ausgebildet sind, Lithium-Ionen reversibel ein- und auslagern zu können,
sowie den zusätzlichen Merkmalen
c. Das Gehäuse umfasst ein becherförmiges erstes Gehäuseteil (102) sowie ein zweites Gehäuseteil (101),
d. Das becherförmige erste Gehäuseteil (102) umfasst einen kreisförmigen oder ovalen Boden (102a),
e. Das becherförmige erste Gehäuseteil (102) umfasst einen ringförmigen Mantel (102b),
f. Der Boden (102a) und der Mantel (102b) des becherförmigen ersten Gehäuseteils (102) weisen jeweils eine in den Innenraum weisende Innenseite und eine in die entgegengesetzte Richtung weisende Außenseite auf, und
g. Der Verbundkörper (104) umfasst einen Stromleiter (108), der die mindestens eine positive Elektrode (105) oder die mindestens eine negative Elektrode (106) elektrisch mit dem becherförmigen ersten Gehäuseteil verbindet,
wobei das Verfahren in beliebiger Reihenfolge die Schritte
h. Bildung einer elektrischen Verbindung zwischen dem Stromleiter (108) und dem becherförmigen ersten Gehäuseteil (102), und
i. Zusammenfügen des ersten Gehäuseteils (102) und des zweiten Gehäuseteils (101) zu dem Gehäuse der Batterie (100) unter Einschluss des Verbundkörpers (104) in dem Innenraum (111),
umfasst und vor den Schritten g. und h.
j. mindestens eine der genannten Innenseiten des becherförmigen ersten Gehäuseteils (102) ganz oder bereichsweise mittels Sputterdeposition mit einer Beschichtung (109) aus Aluminium, Chrom, Zinn oder einer Legierung dieser Elemente versehen wird.

2. Verfahren nach Anspruch 1, **gekennzeichnet durch** die folgenden zusätzlichen Schritte:
a. Die elektrische Verbindung zwischen dem Stromleiter (108) und dem becherförmigen ersten Gehäuseteil (102) wird in einem mit der Beschichtung (109) versehenen Bereich der mindestens einen Innenseite gebildet.
b. Die elektrische Verbindung wird mittels Verschweißung gebildet.
c. Der Stromleiter (108) wird an die Innenseite des Bodens (102a) des becherförmigen Gehäuseteils (102) geschweißt.

3. Verfahren nach Anspruch 1 oder Anspruch 2, **gekennzeichnet durch** mindestens einen der folgenden zusätzlichen Schritte:
a. Die Innenseite des Bodens (102a) wird vollständig mit der Beschichtung (109) versehen.
b. Die Innenseite des Mantels (102b) wird teilweise mit der Beschichtung (109) versehen.

4. Verfahren nach einem der vorhergehenden Ansprüche, **gekennzeichnet durch** den folgenden zusätzlichen Schritt:
a. Die Schichtdicke wird im Bereich von 10 nm bis 10µm eingestellt.

5. Verfahren nach einem der vorhergehenden Ansprüche, **gekennzeichnet durch** mindestens einen der folgenden zusätzlichen Schritte:
a. Es wird ein becherförmiges erstes Gehäuseteil (102) verwendet, in dessen Boden eine Sollrissstelle (110) eingebracht ist.
b. Bei der Sollrissstelle (110) handelt es sich um ein Berstkreuz.

6. Verfahren nach Anspruch 5, **gekennzeichnet durch** den folgenden zusätzlichen Schritt:
a. Im Bereich der Sollrissstelle (110) ist die Innenseite des Bodens (102a) frei von der Beschichtung (109) oder die Beschichtung (109) weist in diesem Bereich eine geringere Dicke auf als in anderen Bereichen des Bodens (102a).

7. Lithium-Ionen-Batterie (100) mit den Merkmalen
a. Sie umfasst ein metallisches, einen Innenraum einschließendes Gehäuse (101, 102), und
b. Sie umfasst einen in dem Innenraum (111) angeordneten Verbundkörper (104) aus mindestens einer positiven Elektrode (105), mindestens einer negativen Elektrode (106) und mindestens einem Separator (112), wobei die Elektroden dazu ausgebildet sind, Lithium-Ionen reversibel ein- und auslagern zu können,
sowie den zusätzlichen Merkmalen
c. Das Gehäuse umfasst ein becherförmiges erstes Gehäuseteil (102) sowie ein zweites Gehäuseteil (101),
d. Das becherförmige erste Gehäuseteil (102) umfasst einen kreisförmigen oder ovalen Boden (102a),
e. Das becherförmige erste Gehäuseteil (102) umfasst einen ringförmigen Mantel (102b),
f. Der Boden (102a) und der Mantel (102b) des becherförmigen ersten Gehäuseteils (102) weisen jeweils eine in den Innenraum (111) weisende Innenseite und eine in die entgegengesetzte Richtung weisende Außenseite auf, und
g. Der Verbundkörper (104) umfasst einen Stromleiter (108), der die mindestens eine positive Elektrode (105) oder die mindestens eine negative Elektrode (106) elektrisch mit dem becherförmigen ersten Gehäuseteil (102) verbindet,
**dadurch gekennzeichnet, dass**
h. auf mindestens eine der Innenseiten ganz oder bereichsweise mittels Sputterdeposition eine Beschichtung (109) aus Aluminium, Chrom, Zinn oder einer Legierung dieser Elemente aufgebracht ist.

8. Batterie (100) nach Anspruch 7, **gekennzeichnet durch** das folgende zusätzliche Merkmal:
a. Der Verbundkörper (104) umfasst die Elektroden (105, 106) in gestapelter Form oder in gewickelter Form.

9. Batterie (100) nach einem der Ansprüche 7 oder 8, **gekennzeichnet durch** die folgenden zusätzlichen Merkmale:
a. Die Elektroden (105, 106) umfassen jeweils einen Stromkollektor (107, 108) der teilweise mit einem Aktivmaterial bedeckt ist.
b. Der Stromleiter (108) ist ein nicht mit dem Aktivmaterial bedeckter Teil des Stromkollektors.

10. Batterie (100) nach einem der Ansprüche 7 bis 9, **gekennzeichnet durch** mindestens eines der folgenden zusätzlichen Merkmale:
a. Das becherförmige erste Gehäuseteil 102 besteht aus Stahl oder Edelstahl.
b. Die Außenseite des becherförmigen ersten Gehäuseteils ist mit einer Schicht aus Nickel bedeckt.

11. Batterie (100) nach einem der Ansprüche 7 bis 10, **gekennzeichnet durch** mindestens eines der folgenden zusätzlichen Merkmale:
a. DerStromleiter(108) besteht aus Aluminium oder aus einerAluminiumlegierung.
b. Der Stromleiter (107) besteht aus Kupfer oder aus einer Kupferlegierung.
c. Der Stromleiter (108) basiert auf dem gleichen Metall wie die Beschichtung auf der mindestens einen Innenseite.

12. Batterie (100) nach einem der Ansprüche 7 bis 11, **gekennzeichnet durch** mindestens eines der folgenden zusätzlichen Merkmale:
a. Das zweite Gehäuseteil (101) ist gleichfalls becherförmig ausgebildet.
b. Die Batterie (100) ist eine Knopfzelle.

## Claims

1. Process for producing a lithium ion battery (100) having the features
a. it comprises a metallic housing (101, 102) enclosing an interior space (111) and
b. it comprises a composite body (104) which is arranged in the interior space (111) and is made up of at least one positive electrode (105), at least one negative electrode (106) and at least one separator (112), wherein the electrodes are configured so as to be able to incorporate and release lithium ions reversibly,
and also the additional features
c. the housing comprises a cup-shaped first housing part (102) and a second housing part (101),
d. the cup-shaped first housing part (102) comprises a circular or oval bottom (102a),
e. the cup-shaped first housing part (102) comprises a ring-shaped side wall (102b),
f. the bottom (102a) and the side wall (102b) of the cup-shaped first housing part (102) each have an inside facing the interior space and an outside facing in the opposite direction, and
g. the composite body (104) comprises a current conductor (108) which electrically connects the at least one positive electrode (105) or the at least one negative electrode (106) to the cup-shaped first housing part,
wherein the process comprises, in any order, the steps
h. establishment of an electrical connection between the current conductor (108) and the cup-shaped first housing part (102), and
i. assembly of the first housing part (102) and the second housing part (101) to form the housing of the battery (100) with inclusion of the composite body (104) in the interior space (111),
and before the steps g. and h.
j. at least one of the specified insides of the cup-shaped first housing part (102) is provided in its entirety or in regions with a coating (109) composed of aluminium, chromium, tin or an alloy of these elements by means of sputter deposition.

2. Process according to Claim 1, **characterized by** the following additional steps:
a. The electrical connection between the current conductor (108) and the cup-shaped first housing part (102) is formed in a region of the at least one inside which is provided with the coating (109).
b. The electrical connection is formed by means of welding.
c. The current conductor (108) is welded to the inside of the bottom (102a) of the cup-shaped housing part (102) .

3. Process according to Claim 1 or Claim 2, **characterized by** at least one of the following additional steps:
a. The inside of the bottom (102a) is provided over its entirety with the coating (109).
b. The inside of the side wall (102b) is provided in part with the coating (109).

4. Process according to any of the preceding claims, **characterized by** the following additional step:
a. The layer thickness is set in the range from 10 nm to 10 µm.

5. Process according to any of the preceding claims, **characterized by** at least one of the following additional steps:
a. A cup-shaped first housing part (102) into the bottom of which an intended rupture position (110) has been introduced is used.
b. The intended rupture position (110) is a bursting cross.

6. Process according to Claim 5, **characterized by** the following additional step:
a. The inside of the bottom (102a) is free of the coating (109) in the region of the intended rupture position (110) or the coating (109) in this region has a lower thickness than in other regions of the bottom (102a).

7. Lithium ion battery (100) having the features
a. it comprises a metallic housing (101, 102) enclosing an interior space and
b. it comprises a composite body (104) which is arranged in the interior space (111) and is made up of at least one positive electrode (105), at least one negative electrode (106) and at least one separator (112), wherein the electrodes are configured so as to be able to incorporate and release lithium ions reversibly,
and also the additional features
c. the housing comprises a cup-shaped first housing part (102) and a second housing part (101),
d. the cup-shaped first housing part (102) comprises a circular or oval bottom (102a),
e. the cup-shaped first housing part (102) comprises a ring-shaped side wall (102b),
f. the bottom (102a) and the side wall (102b) of the cup-shaped first housing part (102) each have an inside facing the interior space (111) and an outside facing in the opposite direction, and
g. the composite body (104) comprises a current conductor (108) which electrically connects the at least one positive electrode (105) or the at least one negative electrode (106) to the cup-shaped first housing part (102),
**characterized in that**
h. a coating (109) composed of aluminium, chromium, tin or an alloy of these elements has been applied to the entirety or regions of at least one of the insides by means of sputter deposition.

8. Battery (100) according to Claim 7, **characterized by** the following additional feature:
a. The composite body (104) comprises the electrodes (105, 106) in stacked form or in rolled form.

9. Battery (100) according to either Claim 7 or 8, **characterized by** the following additional features:
a. The electrodes (105, 106) each comprise a current collector (107, 108) which is partly covered with an active material.
b. The current conductor (108) is a part of the current collector which is not covered with the active material.

10. Battery (100) according to any of Claims 7 to 9, **characterized by** at least one of the following additional features:
a. The cup-shaped first housing part (102) consists of steel or stainless steel.
b. The outside of the cup-shaped first housing part is covered with a layer of nickel.

11. Battery (100) according to any of Claims 7 to 10, **characterized by** at least one of the following additional features:
a. The current conductor (108) consists of aluminium or of an aluminium alloy.
b. The current conductor (107) consists of copper or of a copper alloy.
c. The current conductor (108) is based on the same metal as the coating on the at least one inside.

12. Battery (100) according to any of Claims 7 to 11, **characterized by** at least one of the following additional features:
a. The second housing part (101) likewise has a cup-shaped configuration.
b. The battery (100) is a button cell.

## Revendications

1. Procédé de fabrication d'une batterie à ions lithium (100) présentant les caractéristiques suivantes :
a. elle comprend un boîtier métallique (101, 102) renfermant un espace intérieur (111), et
b. elle comprend un corps composite (104) qui est disposé dans l'espace intérieur (111) et qui comprend au moins une électrode positive (105), au moins une électrode négative (106) et au moins un séparateur (112), les électrodes étant conçues pour pouvoir stocker et déstocker des ions lithium de manière réversible,
ainsi que les caractéristiques supplémentaires suivantes :
c. le boîtier comprend une première partie de boîtier en forme de timbale (102) et une deuxième partie de boîtier (101),
d. la première partie de boîtier en forme de timbale (102) comprend un fond circulaire ou ovale (102a),
e. la première partie de boîtier en forme de timbale (102) comprend une surface latérale annulaire (102b),
f. le fond (102a) et la surface latérale (102b) de la première partie de boîtier en forme de timbale (102) comportent chacun un côté intérieur orienté vers l'espace intérieur et un côté extérieur orienté dans la direction opposée, et
g. le corps composite (104) comprend un conducteur de courant (108) qui relie électriquement l'au moins une électrode positive (105) ou l'au moins une électrode négative (106) à la première partie de boîtier en forme de timbale,
le procédé comprenant les étapes suivantes dans un ordre quelconque
h. former une liaison électrique entre le conducteur de courant (108) et la première partie de boîtier en forme de timbale (102), et
i. assembler la première partie de boîtier (102) et la deuxième partie de boîtier (101) pour former le boîtier de la batterie (100), incluant le corps composite (104) dans l'espace intérieur (111),
et avant les étapes g. et h.
j. au moins un des côtés intérieurs mentionnés de la première partie de boîtier en forme de timbale (102) étant entièrement ou par zones recouvert d'un revêtement (109) en aluminium, en chrome, en étain ou en un alliage de ces éléments par dépôt par pulvérisation cathodique.

2. Procédé selon la revendication 1, **caractérisé par** les étapes supplémentaires suivantes :
a. la liaison électrique entre le conducteur de courant (108) et la première partie de boîtier en forme de timbale (102) est formée dans une zone de l'au moins un côté intérieur qui est pourvue du revêtement (109),
b. la liaison électrique est formée par soudage,
c. le conducteur de courant (108) est soudé au côté intérieur du fond (102a) de la partie de boîtier en forme de timbale (102).

3. Procédé selon la revendication 1 ou la revendication 2, **caractérisé par** au moins une des étapes supplémentaires suivantes :
a. le côté intérieur du fond (102a) est entièrement recouvert du revêtement (109),
b. le côté intérieur de l'enveloppe latérale (102b) est partiellement pourvu du revêtement (109).

4. Procédé selon l'une des revendications précédentes, **caractérisé par** l'étape supplémentaire suivante :
a. l'épaisseur de la couche est réglée dans la plage allant de 10 nm à 10 µm.

5. Procédé selon l'une des revendications précédentes, **caractérisé par** au moins une des étapes supplémentaires suivantes :
a. une première partie de boîtier en forme de timbale (102) est utilisée au fond de laquelle est introduit un point de fissuration (110),
b. le point de fissuration (110) est une croix de rupture.

6. Procédé selon la revendication 5, **caractérisé par** l'étape supplémentaire suivante :
a. dans la zone du point de fissuration (110), le côté intérieur du fond (102a) est dépourvu du revêtement (109) ou le revêtement (109) a une épaisseur plus faible dans cette zone que dans d'autres zones du fond (102a).

7. Batterie à ions lithium (100) présentant les caractéristiques suivantes :
a. elle comprend un boîtier métallique (101, 102) qui renferme un espace intérieur, et
b. elle comprend un corps composite (104) qui est disposé dans l'espace intérieur (111) et qui comprend au moins une électrode positive (105), au moins une électrode négative (106) et au moins un séparateur (112), les électrodes étant conçues pour pouvoir stocker et déstocker des ions lithium de manière réversible,
ainsi que les caractéristiques supplémentaires suivantes :
c. le boîtier comprend une première partie de boîtier en forme de timbale (102) et une deuxième partie de boîtier (101),
d. la première partie de boîtier en forme de timbale (102) comprend un fond circulaire ou ovale (102a),
e. la première partie de boîtier en forme de timbale (102) comprend une surface latérale annulaire (102b),
f. le fond (102a) et la surface latérale (102b) de la première partie de boîtier en forme de timbale (102) comportent chacun un côté intérieur orienté vers l'espace intérieur (111) et un côté extérieur orienté dans la direction opposée, et
g. le corps composite (104) comprend un conducteur de courant (108) qui relie électriquement l'au moins une électrode positive (105) ou l'au moins une électrode négative (106) à la première partie de boîtier en forme de timbale (102),
**caractérisée en ce que**
h. un revêtement (109) en aluminium, en chrome, en étain ou en un alliage de ces éléments est appliqué sur au moins un des côtés intérieurs entièrement ou par zones par dépôt par pulvérisation cathodique.

8. Batterie (100) selon la revendication 7, **caractérisée par** la caractéristique supplémentaire suivante :
a. le corps composite (104) comprend les électrodes (105, 106) sous une forme empilée ou enroulée.

9. Batterie (100) selon l'une des revendications 7 ou 8, **caractérisée par** les caractéristiques supplémentaires suivantes :
a. les électrodes (105, 106) comprennent chacune un collecteur de courant (107, 108) qui est partiellement recouvert d'un matériau actif,
b. le conducteur de courant (108) est une partie du collecteur de courant qui n'est pas recouverte du matériau actif.

10. Batterie (100) selon l'une des revendications 7 à 9, **caractérisée par** au moins une des caractéristiques supplémentaires suivantes :
a. la première partie de boîtier en forme de timbale 102 est en acier ou en acier spécial.
b. le côté extérieur de la première partie de boîtier en forme de timbale est recouvert d'une couche de nickel.

11. Batterie (100) selon l'une des revendications 7 à 10, **caractérisée par** au moins une des caractéristiques supplémentaires suivantes :
a. le conducteur de courant (108) est en aluminium ou en alliage d'aluminium,
b. le conducteur de courant (107) est en cuivre ou en alliage de cuivre,
c. le conducteur de courant (108) est à base du même métal que le revêtement sur l'au moins un côté intérieur.

12. Batterie (100) selon l'une des revendications 7 à 11, **caractérisée par** au moins une des caractéristiques supplémentaires suivantes :
a. la deuxième partie de boîtier (101) est également en forme de timbale,
b. la batterie (100) est une pile bouton.
